# EUROPEAN PATENT SPECIFICATION

(11) **EP 3 579 306 B1**
(45) Date of publication and mention of the grant of the patent: **21.01.2026**
(21) Application number: 17894771.9
(22) Date of filing: 12.12.2017
(51) Int. Cl.: H01M 10/42, H05K 1/02, H01R 12/51, H01M 10/04, H01R 13/652, H01M 50/209, H01M 50/224, H01M 50/271, H01M 50/296, H01M 50/588, H01M 50/591, H01M 50/519, H01M 50/50

(54) **BATTERY MODULE**
BATTERIEMODUL
MODULE DE BATTERIE

(30) Priority: 03.02.2017 KR 20170015582
(43) Date of publication of application: 11.12.2019
(73) Proprietor: Samsung SDI Co., Ltd., Yongin-si, Gyeonggi-do 17084 (KR)
(72) Inventor: RO, Hun Tae, Yongin-si Gyeonggi-do 17084 (KR)
(74) Representative: Gulde & Partner
(86) International application number: PCT/KR2017/014502
(87) International publication number: WO 2018/143556

(56) References cited:
- WO-A1-2016/204470
- KR-A- 20080 025 430
- KR-A- 20090 116 976
- KR-A- 20140 130 357
- US-A1- 2012 003 505
- US-A1- 2012 214 024
- US-A1- 2013 288 105
- US-A1- 2015 131 243

## Description

### [Technical Field]

The present invention relates to a battery module using a pair of end plates.

### [Background Art]

In general, battery cells are used as energy sources for mobile devices, electric vehicles, hybrid vehicles, or electric bicycles, and may be used in various types according to the kinds of available external devices.

Small mobile devices, such as mobile phones, can operate for a predetermined time with the output and capacity of a single battery. However, when a high-power and long-time operation is required like in an electrical vehicle or a hybrid vehicle consuming a large amount of electricity, a large-capacity battery module is constructed by electrically connecting multiple battery cells to increase the output and capacity. The battery module can increase an output voltage or output current according to the number of battery cells included in the battery module. A battery pack may be provided by electrically connecting multiple battery modules.

Meanwhile, the battery module may be deteriorated due to electromagnetic compatibility (EMC) or electrostatic discharge (ESD) induced to a circuit board, which is a problem to be solved. Specifically, there is a need to deal with ESD energy induced to a low-voltage (LV) connector.

US 2012/214024 A1 provides a battery pack including: a core pack; a protection circuit module electrically connected to the core pack and including a connector for further electrically connecting to an external electronic device; and a metallic cover for covering the core pack and the protection circuit module while exposing the connector to the outside, the metallic cover including a protrusion adjacent to a ground portion of the connector.

US 2013/288105 A1 describes a battery module including a plurality of battery cells, a pair of side plates, and a pair of end plates. The side plates are disposed on opposite sides of the plurality of battery cells and the end plates are disposed at opposite ends of the battery module. The side plates include a first mating portion and the end plates include a second mating portion that engages the first mating portion to provide an interference fit. The interference fit joins the side plates and the end plates together and bands the plurality of cells together between the side plates and the end plates.

US 2015/131243 A1 discloses an electronic device including a circuit board, a connector and a noise suppression assembly. The circuit board includes a substrate having a surface layer. The connector is disposed on the circuit board and has at least one electrical pin. The noise suppression assembly includes a wiring area located on the surface layer and adjacent to the connector and a conductive cover member. The wiring area includes at least one electrical contact, a transmission circuit and at least one ground contact, the electrical contact is used for being in electrical contact with the electrical pin of the connector. The transmission circuit is electrically connected to the electrical contact.

### [Technical Problems to be Solved]

The present invention provides a battery module configured to deal with ESD induced to a low-voltage connector thereof.

### [Technical Solutions]

In accordance with a first aspect of the present invention, the above and other objects can be accomplished by providing a battery module comprising: a multiplicity of battery cells arranged in one direction; a circuit board stably placed on upper parts of multiple battery cells; a bus bar electrically connecting the multiple battery cells and electrically connected to the circuit board; and a pair of end plates, the end plates of the pair of end plates being respectively positioned at facing opposite end cells among the multiple battery cells which are arranged in the one direction; wherein the circuit board comprises a connector located at one end thereof and exposed to an exterior side of the battery module to be electrically connected with an external device, and at least one of the pair of end plates is made of a metallic material and comprises a connector grounding part located around the connector, and a connection part connected to the connector grounding part.

In an embodiment, the connector grounding part and the connection part are made of the same material as the end plates made of a metallic material.

In an embodiment, the battery module may further include a pair of side plates coupled to the pair of end plates so as to cover short side surfaces of the multiple battery cells, and an upper cover coupled to the end plates and the side plates to

protect the bus bar and the circuit board, wherein the connector is exposed to an exterior side of the upper cover.

In an embodiment, the connector grounding part may be located at an entrance part of an outer end of the connector so as to have a predetermined thickness, conforming to the edge of the entrance part.

In an embodiment, the pair of end plates and the pair of side plates may be made of a metallic material and may be grounded.

In an embodiment, the upper cover may be made of an insulating material.

In accordance with a second aspect of the present invention, the above and other objects can be accomplished by providing a battery module comprising: a circuit board stably placed on upper parts of multiple battery cells; a bus bar electrically connecting the multiple battery cells and electrically connected to the circuit board; a pair of end plates respectively positioned at facing opposite end cells among the multiple battery cells which are arranged in one direction; a pair of side plates coupled to the pair of end plates so as to cover short side surfaces of the multiple battery cells; an upper cover coupled to the end plates and the side plates to protect the bus bar and the circuit board; and a connector located at one end of the circuit board and exposed to an exterior side of the battery module to be electrically connected with an external device, wherein the connector comprises a metallic connector housing located outside an entrance part of the connector, and the connector housing comprises a grounding pin connection part electrically connected to a grounding pin among connecting pins of the connector, wherein the grounding pin of the connector connected to the grounding pin connection part of the connector housing is connected to the metallic material of the battery module through a pattern of the circuit board.

In accordance with an unclaimed third aspect of the present invention, the above and other objects can be accomplished by providing a pair of end plates for a battery module according to the first aspect, wherein the end plates of the pair of end plates are configured for being positioned at opposite end cells of multiple battery cells arranged in the one direction, and wherein the pair of end plates comprises: a main plate made of a metallic material and having an area corresponding to the size of one side surface of the battery module; a connector grounding part made of a metallic material and configured for being located around a connector of the battery module, when the main plate is positioned at one of the end cells; and a connection part made of a metallic material and connecting the connector grounding part and the main plate.

### [Advantageous Effects]

As described above, the battery module according to an embodiment of the present invention can effuse ESD induced to a low-voltage connector by grounding the ESD using an external metal case through a metallic edge located outside the connector.

In addition, the battery module according to an embodiment of the present invention can ground ESD induced to a low-voltage connector by connecting an external metal case located outside the connector to a ground line among various internal lines of the connector.

### [Brief Description of Drawings]

FIG. 1 is an exploded perspective view of an upper cover of a battery module according to an embodiment of the present invention.
FIG. 2 is a perspective view of an end plate of the battery module according to an embodiment of the present invention.
FIG. 3 is a perspective view of a battery module according to another embodiment of the present invention.
FIG. 4 is a perspective view of a connector of the battery module according to another embodiment of the present invention.
FIG. 5 is a front view of the connector shown in FIG. 4.

### [Best Mode for Carrying Out the Invention]

Hereinafter, a preferred embodiment of the present invention will be described in detail.

Various embodiments of the present invention may be embodied in many different forms and should not be construed as being limited to the example embodiments set forth herein. Rather, these example embodiments of the disclosure are provided so that this disclosure will be thorough and complete and will convey inventive concepts of the disclosure to those skilled in the art.

In the accompanying drawings, sizes or thicknesses of various components are exaggerated for brevity and clarity. Like numbers refer to like elements throughout. As used herein, the term "and/or" includes any and all combinations of one or more of the associated listed items. In addition, it will be understood that when an element A is referred to as being "connected to" an element B, the element A can be directly connected to the element B or an intervening element C may be present and the element A and the element B are indirectly connected to each other.

The terminology used herein is for the purpose of describing particular embodiments only and is not intended to be limiting of the disclosure. As used herein, the singular forms are intended to include the plural forms as well, unless the context clearly indicates otherwise. It will be further understood that the terms "comprise or include" and/or "comprising or including," when used in this specification, specify the presence of stated features, numbers, steps, operations, elements, and/or components, but do not preclude the presence or addition of one or more other features, numbers, steps, operations, elements, components, and/or groups thereof.

It will be understood that, although the terms first, second, etc. may be used herein to describe various members, elements, regions, layers and/or sections, these members, elements, regions, layers and/or sections should not be limited by these terms. These terms are only used to distinguish one member, element, region, layer and/or section from another. Thus, for example, a first member, a first element, a first region, a first layer and/or a first section discussed below could be termed a second member, a second element, a second region, a second layer and/or a second section without departing from the teachings of the present disclosure.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "on" or "above" the other elements or features. Thus, the exemplary term "below" can encompass both an orientation of above and below.

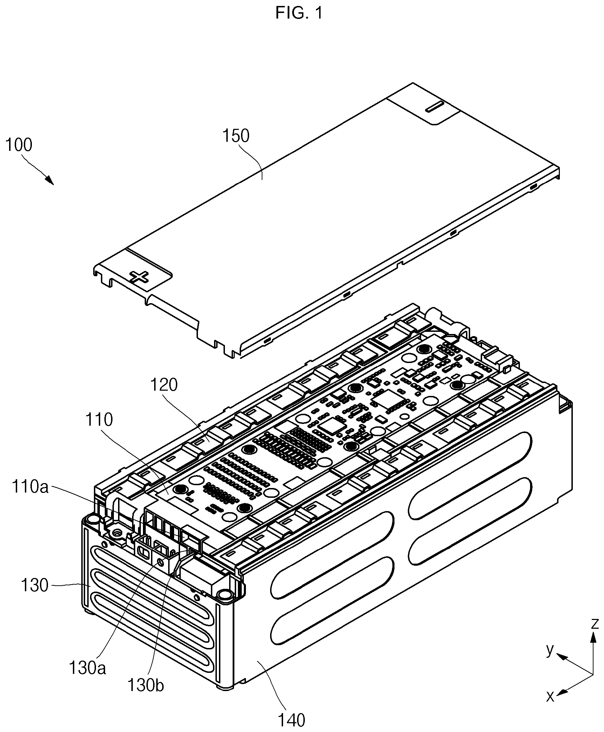

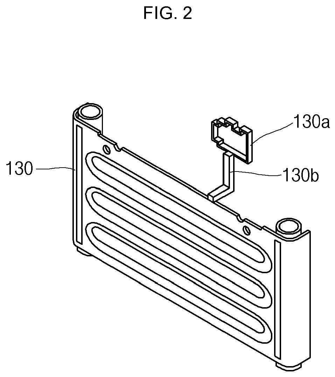

FIG. 1 is an exploded perspective view of an upper cover of a battery module according to an embodiment of the present invention. FIG. 2 is a perspective view of an end plate of the battery module according to an embodiment of the present invention.

Referring to FIGS. 1 and 2, the battery module 100 according to an embodiment of the present invention includes multiple battery cells, an inner cover, a circuit board 110, bus bars 120, end plates 130, side plates 140, and an upper cover 150.

A battery cell (not shown) is an energy generating device and is comprised of multiple battery cells to be arranged in a first direction x, although not shown. The battery cell may include a case having an opening located at its top surface and an electrode assembly accommodated in the case with an electrolyte. The opening of the case may be sealed by a cap assembly. In addition, electrode terminals having different polarities, that is, a positive electrode terminal and a negative electrode terminal, may be provided in the cap assembly defining a top surface of the battery cell.

An inner cover (not shown) is positioned on upper parts of the multiple battery cells, and multiple bus bars 120 for electrically connecting the multiple battery cells are placed on the inner cover. The inner cover may be sized to cover the entire upper parts of the multiple battery cells. In addition, the inner cover may include a plurality of holes for exposing electrode terminals of the multiple battery cells to the upper parts of the multiple battery cells. The inner cover is preferably made of an insulating material.

The circuit board 110 is coupled to an upper part of the inner cover and includes electronic devices for controlling and monitoring charge/discharge states of the multiple battery cells. The circuit board 110 may be coupled to the center of the bus bars 120 on the inner cover so as to be spaced apart from the bus bars 120 arranged in opposite sides of the circuit board 110. That is to say, the circuit board 110 is placed at the center of the upper part of the inner cover in the first direction x, and multiple bus bars 120 for electrically connecting the multiple cells are placed at opposite sides of the circuit board 110 in the first direction x. In addition, the circuit board 110 may be electrically connected to the bus bars 120. The bus bars 120 may be electrically connected to input/output terminals located on a bottom surface of the circuit board 110. That is to say, a circuit board connection part of the bus bars 120 may be connected to the input/output terminals provided on the bottom surface of the circuit board 110. In addition, the circuit board 110 includes a connector 110a exposed to an exterior side of the battery module 100 to be electrically connected to an external device. The connector 110a may be a low-voltage (LV) connector.

The bus bars 120 connect the battery cells to one another in series or in parallel by connecting electrode terminals of neighboring ones among the battery cells. The bus bars 120 are brought into contact with and connected to electrode terminals of upwardly exposed through the inner cover and are supported by the inner cover. The bus bars 120 may electrically connect the electrode terminals arranged on the same columns among the multiple battery cells arranged in the first direction x. That is to say, the bus bars 120 may be arranged at opposite sides on the inner cover in the first direction x so as to be spaced apart from each other. The bus bars 120 may include a circuit board connection part protruding toward the circuit board 110. The circuit board connection part may be coupled to the circuit board 110 to then be electrically connected thereto.

The end plates 130 are positioned at facing opposite end cells among the multiple battery cells which are arranged in one direction, respectively. At least one of the end plates 130 positioned at the opposite end cells is made of a metallic material, and the end plate 130 made of the metallic material further includes a connector grounding part 130a and a connection part 130b. The connector grounding part 130a is configured to enclose the connector 110a at an entrance part of the connector 110a of the circuit board 110. That is to say, the connector grounding part 130a may be located at the entrance part of the outer end of the connector 110a so as to have a predetermined thickness, conforming to the edge of the entrance part, as shown in FIG. 2, and may be shaped of a rectangular ring as a whole. Meanwhile, the connector grounding part 130a may extend to enclose the whole connector 110a or may extend to enclose only top and side surfaces of the connector 110a. The connection part 130b is a metallic connection line extending from the main plate of the end plates 130 to the connector grounding part 130a. The connection part 130b may be provided so as to be adapted to the curved outer surface shape of the battery module 100 according to the external shape of the battery module 100. The connector grounding part 130a and the connection part 130b may be made of the same material as the end plates 130. In addition, the end plate 130 having the connector grounding part 130a and the connection part 130b may further include an external ground line to be grounded. When the end plate 130 is capable of absorbing ESD energy, the external ground line may not be needed.

As described above, since the connector grounding part 130a enclosing the connector 110a of the circuit board 110 is made of a metallic material, the ESD induced to the connector 110a, specifically, to a low-voltage connector, may be allowed to flow out to the end plates 130, which define a metal case, along the connector grounding part 130a exposed to an exterior side of the battery module 100 through the connection part 130b, and to finally flow out to the ground. Accordingly, the ESD or EMC problem arising in the battery module 100 used for an electric car can be solved.

Meanwhile, one end plate 130 of the pair of end plates 130, including the connector grounding part 130a and the connection part 130b, and the other end plate 130b opposite to the one end plate 130a, are made of the same metal, thereby protecting the battery module 100 using the metal case.

In addition, the side plates 140 may be coupled to the pair of end plates 130 so as to cover the short side surfaces of the multiple battery cells. That is to say, the multiple battery cells may be arranged in the first direction x in a space defined by the pair of end plates 130 and the pair of side plates 140.

The upper cover 150 may be combined with the end plates 130 and the side plates 140 to protect the bus bars 120 and the circuit board 110 from external circumferences. The upper cover 150 may be made of an insulating material.

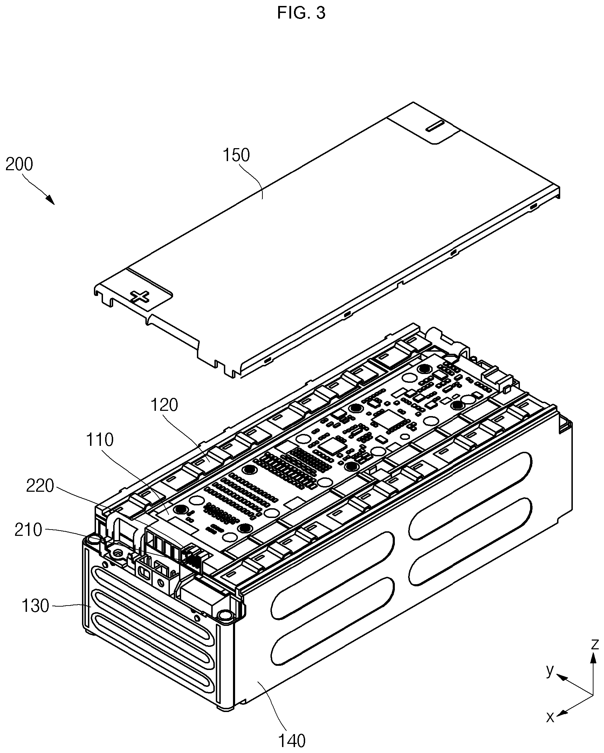

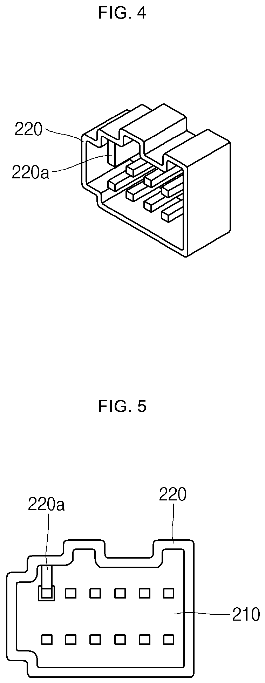

FIG. 3 is a perspective view of a battery module according to another embodiment of the present invention. FIG. 4 is a perspective view of a connector of the battery module according to another embodiment of the present invention. FIG. 5 is a front view of the connector shown in FIG. 4.

Referring to FIGS. 3 to 5, the battery module 200 according to another embodiment of the present invention includes multiple battery cells, an inner cover, a circuit board 110, bus bars 120, end plates 130, side plates 140, and an upper cover 150, like the battery module 100 shown in FIG. 1.

The multiple battery cells, the inner cover, the circuit board 110, the bus bars 120, the side plates 140, and the upper cover 150 of the battery module 200 include the same components of the corresponding functional units of the battery module 100, except for the end plates 130 of the battery module 100. That is to say, unlike the end plates 130 of the battery module 100, the end plates 130 of the battery module 200 are not provided with a connector grounding part and a connection part.

Meanwhile, the circuit board 110 of the battery module 200 includes a connector 210, which is different from the connector 110a of the battery module 100 shown in FIG. 1. Referring to FIGS. 4 and 5, the connector 210 includes a metallic connector housing 220 located outside the connector 210. The connector housing 220 may be fabricated to enclose an inner housing made of an insulating material (not shown). Alternatively, the connector housing 220 may be fabricated to enclose multiple connector pins without an inner housing. Otherwise, the connector housing 220 may also be fabricated to enclose only a top surface of an insulating housing or only top and side surfaces of the insulating housing. Or else, the connector housing 220 may be located only on an upper portion of an entrance part of the connector 210.

The connector housing 220 includes a grounding pin connection part 220a electrically connected to a grounding pin led to a grounding line among multiple connecting pins of the connector 210. The grounding pin connection part 220a may protrude and extend from an inner surface of the connector housing 220 to then be integrally formed with the grounding pin. Alternatively, the grounding pin connection part 220a may be fabricated to enclose the grounding pin such that it extends from the inner surface of the connector housing 220 so as to be electrically connected to the grounding pin. FIG. 4 shows that the grounding pin connection part 220a is integrally formed with the grounding pin of the connector 210. FIG.5 shows the grounding pin connection part 220a encloses the edge of the grounding pin of the connector 210 to be electrically connected to the grounding pin of the connector 210.

In addition, the grounding pin of the connector 210 connected to the grounding pin connection part 220a of the connector housing 220 is connected to a metallic material of the battery module 200 through a pattern of the circuit board 110. The metallic material may correspond to the end plates 130 or the side plates 140. Alternatively, the metallic material may correspond to an external grounding line.

As described above, in the battery module 200 according to another embodiment of the present invention, the ESD generated in vicinity of the connector 210 flows out to the grounding pin connection part 220a and the grounding pin through the connector housing 220. The ESD having flowed out to the grounding pin will be grounded to the metallic material of the battery module 200 through the pattern of the circuit board or an external grounding line. Therefore, the ESD or EMC problem with the battery module 200 used for an electric car can be solved.

Although the foregoing embodiments have been described to practice the battery module of the present invention, these embodiments are set forth for illustrative purposes and do not serve to limit the invention.

## Claims

1. A battery module (100) comprising:
a multiplicity of battery cells arranged in one direction (x);
a circuit board (110) stably placed on upper parts of the multiple battery cells;
a bus bar (120) electrically connecting the multiple battery cells and electrically connected to the circuit board (110); and
a pair of end plates (130) the end plates of the pair of end plates (130) being respectively positioned at facing opposite end cells among the multiple battery cells which are arranged in the one direction (x),
wherein the circuit board (110) comprises a connector (110a) located at one end thereof and exposed to an exterior side of the battery module (100) to be electrically connected with an external device, and at least one of the pair of end plates is made of metallic material and comprises a connector grounding part (130a) located around the connector (110a), and a connection part (130b) connected to the connector grounding part (130a).

2. The battery module of claim 1, wherein the connector grounding pa and the connection part are made of the same material as the end plates made of a metallic material and are grounded to the end plates.

3. The battery module of claim 1 or 2, further comprising:
a pair of side plates coupled to the pair of end plates so as to cover short side surfaces of the multiple battery cells; and
an upper cover coupled to the end plates and the side plates to protect the bus bar and the circuit board,
wherein the connector is exposed to an exterior side of the upper cover.

4. The battery module of any one of claims 1 to 3, wherein the connector grounding part is located at an entrance of an outer end of the connector so as to have a predetermined thickness, conforming to the edge of the entrance.

5. The battery module of claim 3, wherein the pair of end plates and the pair of side plates are made of a metallic material and are grounded.

6. The battery module of claim 3, wherein the upper cover is made of an insulating material.

7. A battery module (200) comprising:
a circuit board (110) stably placed on upper parts of multiple battery cells;
a bus bar (120) electrically connecting the multiple battery cells and electrically connected to the circuit board;
a pair of end plates (130) respectively positioned at facing opposite end cells among the multiple battery cells which are arranged in one direction (x);
a pair of side plates (140) coupled to the pair of end plates (130) so as to cover short side surfaces of the multiple battery cells;
an upper cover (150) coupled to the end plates (130) and the side plates (140) to protect the bus bar (120) and the circuit board (110); and
a connector (210) located at one end of the circuit board (110) and exposed to an exterior side of the battery module (200) to be electrically connected with an external device,
wherein the connector (210) comprises a metallic connector housing (220) located outside an entrance of the connector (210), and the connector housing (220) comprises a grounding pin connection part (220a) electrically connected to a grounding pin among connecting pins of the connector (210),
wherein the grounding pin of the connector connected to the grounding pin connection part (220a) of the connector housing (220) is connected to the metallic material of the battery module (200) through a pattern of the circuit board (110).

## Patentansprüche

1. Batteriemodul (100), umfassend:
eine Vielzahl von Batteriezellen, die in einer Richtung (x) angeordnet sind;
eine Schaltplatte (110), die stabil auf den oberen Teilen der mehreren Batteriezellen angeordnet ist;
eine Sammelschiene (120), die die mehreren Batteriezellen elektrisch verbindet und elektrisch mit der Schaltplatte (110) verbunden ist; und
ein Paar Endplatten (130), wobei die Endplatten des Paares von Endplatten (130) jeweils an gegenüberliegenden Endzellen unter den mehreren, in der einen Richtung (x) angeordneten Batteriezellen positioniert sind,
wobei die Schaltplatte (110) einen Verbinder (110a) umfasst, der an einem Ende davon angeordnet ist und an einer Außenseite des Batteriemoduls (100) freiliegt, um mit einem externen Gerät elektrisch verbunden zu sein, und wobei mindestens eine des Paares von Endplatten aus einem metallischen Material besteht und ein Verbinder-Erdungsteil (130a), das um den Verbinder (110a) herum angeordnet ist, und ein Verbindungsteil (130b) umfasst, das mit dem Verbinder-Erdungsteil (130a) verbunden ist.

2. Batteriemodul nach Anspruch 1, wobei das Verbinder-Erdungsteil und das Verbindungsteil aus dem gleichen Material wie die Endplatten aus einem metallischen Material bestehen und mit den Endplatten geerdet sind.

3. Batteriemodul nach Anspruch 1 oder 2, umfassend ferner:
ein Paar Seitenplatten, die mit dem Paar Endplatten gekoppelt sind, um die kurzen Seitenflächen der mehreren Batteriezellen abzudecken; und
eine obere Abdeckung, die mit den Endplatten und den Seitenplatten gekoppelt ist, um die Sammelschiene und die Schaltplatte zu schützen,
wobei der Verbinder an einer Außenseite der oberen Abdeckung freiliegt.

4. Batteriemodul nach einem der Ansprüche 1 bis 3, wobei sich das Verbinder-Erdungsteil an einem Eingang eines äußeren Endes des Verbinders befindet, so dass er eine vorbestimmte Dicke aufweist, die der Kante des Eingangs entspricht.

5. Batteriemodul nach Anspruch 3, wobei das Paar Endplatten und das Paar Seitenplatten aus einem metallischen Material bestehen und geerdet sind.

6. Batteriemodul nach Anspruch 3, wobei die obere Abdeckung aus einem isolierenden Material besteht.

7. Batteriemodul (200), umfassend:
eine Schaltplatte (110), die stabil auf den oberen Teilen mehrerer Batteriezellen angeordnet ist;
eine Sammelschiene (120), die die mehreren Batteriezellen elektrisch verbindet und elektrisch mit der Schaltplatte verbunden ist;
ein Paar Endplatten (130), die jeweils an gegenüberliegenden Endzellen unter den mehreren, in einer Richtung (x) angeordneten Batteriezellen positioniert sind;
ein Paar Seitenplatten (140), die mit dem Paar Endplatten (130) gekoppelt sind, um die kurzen Seitenflächen der mehreren Batteriezellen abzudecken;
eine obere Abdeckung (150), die mit den Endplatten (130) und den Seitenplatten (140) gekoppelt ist, um die Sammelschiene (120) und die Schaltplatte (110) zu schützen; und
einen Verbinder (210), der sich an einem Ende der Schaltplatte (110) befindet und an einer Außenseite des Batteriemoduls (200) freiliegt, um elektrisch mit einem externen Gerät verbunden sein,
wobei der Verbinder (210) ein metallisches Verbindergehäuse (220) umfasst, das sich außerhalb eines Eingangs des Verbinders (210) befindet, wobei das Verbindergehäuse (220) ein Erdungsstift-Verbindungsteil (220a) umfasst, das elektrisch mit einem Erdungsstift unter den Verbindungsstiften des Verbinders (210) verbunden ist,
wobei der Erdungsstift des Verbinders, der mit dem Erdungsstift-Verbindungsteil (220a) des Steckverbindergehäuses (220) verbunden ist, über ein Muster der Schaltplatte (110) mit dem metallischen Material des Batteriemoduls (200) verbunden ist.

## Revendications

1. Module de batterie (100) comportant :
une multiplicité d'éléments de batterie agencés dans une direction (x) ;
une carte de circuit imprimé (110) placée de manière stable sur des parties supérieures des multiples éléments de batterie ;
une barre omnibus (120) connectant électriquement les multiples éléments de batterie et connectée électriquement à la carte de circuit imprimé (110) ; et
une paire de plaques d'extrémité (130), les plaques d'extrémité de la paire de plaques d'extrémité (130) étant respectivement positionnées au niveau d'éléments d'extrémité orientés à l'opposé parmi les multiples éléments de batterie qui sont agencés dans la direction (x),
dans lequel la carte de circuit imprimé (110) comporte un connecteur (110a) situé à une extrémité de celle-ci et exposé à un côté extérieur du module de batterie (100) pour être connecté électriquement à un dispositif externe, et au moins l'une de la paire de plaques d'extrémité est constituée d'un matériau métallique et comporte une partie de mise à la terre de connecteur (130a) située autour du connecteur (110a), et une partie de connexion (130b) connectée à la partie de mise à la terre de connecteur (130a).

2. Module de batterie selon la revendication 1, dans lequel la partie de mise à la terre de connecteur et la partie de connexion sont constituées du même matériau que les plaques d'extrémité constituées d'un matériau métallique et sont mises à la terre par rapport aux plaques d'extrémité.

3. Module de batterie selon la revendication 1 ou 2, comportant en outre :
une paire de plaques latérales couplées à la paire de plaques d'extrémité de manière à recouvrir des surfaces latérales courtes des multiples éléments de batterie ; et
un couvercle supérieur couplé aux plaques d'extrémité et aux plaques latérales pour protéger la barre omnibus et la carte de circuit imprimé,
dans lequel le connecteur est exposé à un côté extérieur du couvercle supérieur.

4. Module de batterie selon l'une quelconque des revendications 1 à 3, dans lequel la partie de mise à la terre de connecteur est située au niveau d'une entrée d'une extrémité extérieure du connecteur de manière à avoir une épaisseur prédéterminée, conforme au bord de l'entrée.

5. Module de batterie selon la revendication 3, dans lequel la paire de plaques d'extrémité et la paire de plaques latérales sont constituées d'un matériau métallique et sont mises à la terre.

6. Module de batterie selon la revendication 3, dans lequel le couvercle supérieur est constitué d'un matériau isolant.

7. Module de batterie (200) comportant :
une carte de circuit imprimé (110) placée de manière stable sur des parties supérieures de multiples éléments de batterie ;
une barre omnibus (120) connectant électriquement les multiples éléments de batterie et connectée électriquement à la carte de circuit imprimé ;
une paire de plaques d'extrémité (130) respectivement positionnées au niveau d'éléments d'extrémité orientés à l'opposé parmi les multiples éléments de batterie qui sont agencés dans une direction (x) ;
une paire de plaques latérales (140) couplées à la paire de plaques d'extrémité (130) de manière à recouvrir des surfaces latérales courtes des multiples éléments de batterie ;
un couvercle supérieur (150) couplé aux plaques d'extrémité (130) et aux plaques latérales (140) pour protéger la barre omnibus (120) et la carte de circuit imprimé (110) ; et
un connecteur (210) situé à une extrémité de la carte de circuit imprimé (110) et exposé à un côté extérieur du module de batterie (200) pour être connecté électriquement à un dispositif externe,
dans lequel le connecteur (210) comporte un boîtier de connecteur métallique (220) situé à l'extérieur d'une entrée du connecteur (210), et le boîtier de connecteur (220) comporte une partie de connexion de broche de mise à la terre (220a) connectée électriquement à une broche de mise à la terre parmi des broches de connexion du connecteur (210),
dans lequel la broche de mise à la terre du connecteur connectée à la partie de connexion de broche de mise à la terre (220a) du boîtier de connecteur (220) est connectée au matériau métallique du module de batterie (200) à travers un motif de la carte de circuit imprimé (110).
